Europäisches Patentamt

European Patent Office

Office européen des brevets

(19)

(11) Veröffentlichungsnummer : **0 049 840**
**B1**

(12) **EUROPÄISCHE PATENTSCHRIFT**

(45) Veröffentlichungstag der Patentschrift :
**09.01.85**

(21) Anmeldenummer : **81107889.8**

(22) Anmeldetag : **03.10.81**

(51) Int. Cl.⁴ : **G 03 F   7/26**

(54) **Verfahren zur Herstellung von Reliefkopien.**

(30) Priorität : **13.10.80 DE 3038605**

(43) Veröffentlichungstag der Anmeldung :
**21.04.82 Patentblatt 82/16**

(45) Bekanntmachung des Hinweises auf die Patenterteilung : **09.01.85 Patentblatt 85/02**

(84) Benannte Vertragsstaaten :
**AT BE CH DE FR GB IT LI NL SE**

(56) Entgegenhaltungen :
**DE-A- 2 829 512
FR-A- 2 171 724
US-A- 3 726 679
US-A- 3 915 706
IBM Technical Disclosure Bulletin, vol. 13, no. 2,
juillet 1970, NEW YORK (US), L.H. KAPLAN:
"Exposure time reduction for positive photoresists",
Seite 530
Die Akte enthält technische Angaben, die nach dem
Eingang der Anmeldung eingereicht wurden und die
nicht in dieser Patentschrift enthalten sind.**
(73) Patentinhaber : **HOECHST AKTIENGESELLSCHAFT
Postfach 80 03 20
D-6230 Frankfurt am Main 80 (DE)**

(72) Erfinder : **Buhr, Gerhard, Dr.
Am Erdbeerstein 28
D-6240 Königstein/Ts.4 (DE)**
Erfinder : **Geus, Marie-Luise
Bert-Brecht-Strasse 16
D-6200 Wiesbaden (DE)**

**Beschreibung**

Die Erfindung betrifft ein Verfahren zur Herstellung von Reliefkopien durch bildmäßiges Bestrahlen eines positiv arbeitenden strahlungsempfindlichen Kopiermaterials, das aus einem Schichtträger und einer strahlungsempfindlichen Schicht besteht, und Auswaschen der bestrahlten Schichtbereiche. Die strahlungsempfindliche Schicht enthält eine bei Bestrahlung Säure abspaltende Verbindung und eine Verbindung, die mindestens eine durch Säure spaltbare C—O—C-Gruppe aufweist.

Kopiermaterialien der genannten Art sind bekannt und z. B. in den US-A-3 779 778 und 4 101 323, der DE-PS 27 18 254 und den DE-A1-28 29 512 und 28 29 511 beschrieben. Sie enthalten als säurespaltbare Verbindungen Orthocarbonsäurederivate, monomere oder polymere Acetale, Enolether oder Acyliminocarbonate. Als strahlungsempfindliche, Säure abspaltende Verbindungen enthalten sie vorwiegend organische Halogenverbindungen, insbesondere durch Halogenmethylgruppen substituierte s-Triazine.

Die Strahlungsempfindlichkeit, insbesondere die Empfindlichkeit gegenüber langwelligem UV-Licht, dieser Gemische ist wesentlich höher als die von anderen technisch genutzten Positivsystemen, z. B. von o-Chinondiaziden.

Es wurde jedoch gefunden, daß die Strahlungsempfindlichkeit der Kopiermaterialien auf Basis säurespaltbarer Verbindungen in gewissem Maße davon abhängt, wie viel Zeit zwischen Belichtung und Entwicklung verstreicht, d. h. die maximale praktische Empfindlichkeit wird erst dann erreicht, wenn zwischen Belichtung und Entwicklung einige Minuten vergangen sind. In typischen Fällen tritt bei einer Lagerzeit von etwa drei Minuten zwischen Belichtung und Entwicklung eine Erhöhung der praktischen Lichtempfindlichkeit bis zu 1,5 Keilstufen, d. h. um etwa 70 %, gegenüber dem Wert auf, der bei einem Zeitabstand von 15 Sekunden zwischen Belichtung und Entwicklung ermittelt wird. Wird dieser Zeitabstand auf etwa 5 bis 40 Minuten verlängert, so werden konstante Werte der Empfindlichkeit erreicht.

Um beim Kopieren Konstante, hohe Empfindlichkeitswerte zu erreichen, ist es deshalb zweckmäßig, zwischen der Bildbelichtung und der Entwicklung eine Wartezeit von mindestens 5-10 Minuten einzuhalten. Auf diese Weise geht also der durch die hohe Lichtempfindlichkeit erreichte Zeitgewinn bei der Verarbeitung weitgehend verloren. Man kann zwar bei kontinuierlich ablaufenden Verarbeitungsprozessen, z. B. bei der Fertigung von Druckformen, die belichteten Platten einem Speicher zuführen, aus dem sie nach einer vorbestimmten Verweilzeit abgerufen und entwickelt werden. Bei hohen Plattendurchsätzen, fällt dann die einmalige, vorgeschaltete Wartezeit nicht mehr so erheblich ins Gewicht, jedoch ist der konstruktive Aufwand und Raumbedarf für den Speicher nicht unerheblich, und es besteht im kontinuierlichen Betrieb immer die Gefahr, daß Belichtungsfehler erst dann erkannt werden können, wenn bereits eine große Anzahl von Platten dieser Fehlbelichtung unterworfen worden ist. Auch besteht bei der Verarbeitung einzelner Platten das Bedürfnis, die Vorschaltzeit so weit zu reduzieren, daß der gesamte Verarbeitungsprozeß im Rahmen des sonst üblichen Zeitbedarfs liegt.

Aufgabe der Erfindung war es, ein Verfahren zur Herstellung von Reliefbildern mit einem strahlungsempfindlichen Material der oben beschriebenen Gattung vorzuschlagen, bei dem praktisch keine Wartezeit zwischen Bestrahlung und Entwicklung erforderlich ist und mit dem eine hohe, von der Wartezeit unabhängige Strahlungsempfindlichkeit erreicht wird.

Erfindungsgemäß wird ein Verfahren zur Herstellung von Reliefkopien durch bildmäßiges Bestrahlen eines strahlungsempfindlichen Kopiermaterials aus einem Schichtträger und einer strahlungsempfindlichen Schicht, die

a) eine bei Bestrahlung Säure abspaltende Verbindung und
b) eine Verbindung, die mindestens eine durch Säure spaltbare C—O—C-Gruppe aufweist,

enthält, und Auswaschen der bestrahlten Schichtbereiche mittels eines Entwicklers vorgeschlagen, das dadurch gekennzeichnet ist, daß man zur Erhöhung der Löslichkeit der bestrahlten Bereiche das bildmäßig bestrahlte Kopiermaterial vor dem Auswaschen kurze Zeit erwärmt.

Das Erwärmen lichtempfindlicher Materialien zwischen Belichtung und Entwicklung ist an sich bekannt. So sind in den DE-C-14 47 913 und 16 71 626 sowie in der DE-A1-23 42 068 negativ arbeitende lichtempfindliche Materialien beschrieben, die bei Belichtung Säure bildende Verbindungen und durch Säure vernetzbare bzw. härtbare Verbindungen, zumeist säurehärtbare Kondensationsharze, enthalten. Hier ist in der Regel das Erwärmen notwendig, um überhaupt innerhalb einer vernünftigen Zeit zu einer ausreichenden Bilddifferenzierung zu kommen.

Es sind auch positiv arbeitende, also an den belichteten Stellen löslich werdende Materialien bekannt, bei denen nach der Belichtung erwärmt wird, um eine Bilddifferenzierung zu erreichen. In der DE-C-15 22 495 sind Schichten aus säurehärtbaren Harzen und Jod oder Alkalijodiden beschrieben, bei denen durch Erwärmen die unbelichteten Stellen stärker gehärtet werden als die belichteten.

In der EP-A1-00 05 775 sind positiv arbeitende Photoresistmaterialien beschrieben, deren Reaktionsweise auf einem anderen Mechanismus beruht. Hier wird eine durch Elektronenstrahlung initiierte radikalische Depolymerisation von unlöslichen polymeren Schichtbestandteilen durch Erwärmen beschleunigt, und die Depolymerisationsprodukte werden verdampft, wobei bis zu etwa 30 Minuten erhitzt

2

# 0 049 840

wird. Auch in der DE-OS 29 45 630 wird die Depolymerisation von bestimmten Polymeren durch Erhitzen von mindestens 30 Minuten auf 120-170 °C vervollständigt.

Einen völlig anderen Verlauf nimmt die Solubilisierungsreaktion bei den Gemischen, die im Rahmen des erfindungsgemäßen Verfahrens Verwendung finden. Die durch Einwirkung aktinischer Strahlung erzeugte Säure protoniert die durch Säure spaltbaren Verbindungen und erzeugt dabei direkt oder nach Abspaltung eines Reaktionsprodukts, z. B. eines Moleküls Alkohol oder Phenol, eine reaktive Zwischenverbindung, die Wasser addiert und schließlich in die Endprodukte der Hydrolyse übergeführt wird.

Dieser Reaktionsmechanismus hat bestimmte Gemeinsamkeiten mit der Photoreaktion von o-Naphthochinondiaziden, den technisch am häufigsten verwendeten positiv arbeitenden Verbindungen. Auch hier wird bei Belichtung eine reaktive Zwischenverbindung, ein Keten, gebildet, das nach einem ionischen Mechanismus Wasser addiert und in eine alkalilösliche Indencarbonsäure übergeführt wird. Dieser Prozeß läuft jedoch sehr schnell ab und läßt sich durch eine Wärmebehandlung zwischen Belichtung und Entwicklung nicht beschleunigen. Es ist deshalb besonders überraschend, daß sich die Bildung löslicher Produkte bei den erfindungsgemäß verwendeten lichtempfindlichen Systemen durch Erwärmen beschleunigen läßt.

Die Art der Wärmezufuhr kann weitgehend frei gewählt werden. Sie kann durch Wärmeleitung durch den Schichtträger des Kopiermaterials hindurch, z. B. von einer beheizten Platte oder Walze her, oder mittels eines gasförmigen Wärmeüberträgers erfolgen, z. B. in einem Umlufttrockenschrank. Vorteilhaft ist auch die Einwirkung von Infrarotstrahlung oder anderer elektromagnetischer Strahlung mit Wellenlängen außerhalb des Aktivierungsbereichs der Säure abspaltenden Verbindung. Wesentlich ist allein eine Temperaturerhöhung der bestrahlten Kopierschicht auf Werte deutlich oberhalb der Raumtemperatur. Die Schicht sollte im allgemeinen eine Temperatur im Bereich von etwa 40-130 °C erreichen. Der bevorzugte Bereich liegt bei 50 bis 100 °C, besonders bevorzugt werden Temperaturen zwischen 65 und 90 °C.

Temperaturen unterhalb 40 °C bewirken im allgemeinen keine ausreichende Beschleunigung der Solubilisierungsreaktion, Temperaturen deutlich oberhalb 130 °C wirken sich in vielen Fällen bereits ungünstig auf die Wiedergabe feinster Bildelemente aus. Es ist anzunehmen, daß hier schon die unbelichtete Schicht durch Wärme verändert wird.

Die Dauer des Erhitzens sollte zweckmäßig etwa 0,5 bis 2 Minuten betragen.

Die lichtempfindlichen Gemische, die bei dem erfindungsgemäßen Verfahren verwendet werden, sind, wie bereits erwähnt, bekannt. Geeignete Gemische auf Basis säurespaltbarer Verbindungen sind in den eingangs genannten Druckschriften beschrieben.

Von den in der US-A-4 101 323 beschriebenen Orthocarbonsäurederivaten werden insbesondere die Diphenoxymethylether aliphatischer oder aromatischer Hydroxyverbindungen, die N-Diphenoxymethylderivate von Lactamen sowie ganz besonders die Bis-1,3-dioxan-2-yl-ether von aliphatischen Diolen verwendet.

Von den in der DE-C-27 18 254 beschriebenen Polyacetalen werden diejenigen mit aliphatischen Aldehyd- und Dioleinheiten bevorzugt.

Weitere gut geeignete Gemische sind in der älteren deutschen Patentanmeldung P 29 28 630.0 beschrieben. Dort werden als säurespaltbare Verbindungen polymere Orthester mit wiederkehrenden Orthoestergruppen in der Hauptkette beschrieben.

Diese Gruppen sind 2-Alkylether von 1,3-Dioxa-cycloalkanen mit 5 oder 6 Ringgliedern. Besonders bevorzugt werden Polymere mit wiederkehrenden 1,3-Dioxa-cyclohex-2-yl-alkylethereinheiten, in denen die Alkylethergruppe durch Ethersauerstoffatome unterbrochen sein kann und bevorzugt an die 5-Stellung des benachbarten Rings gebunden ist. Ein Teil dieser polymeren Orthoester ist auch in der DE-A1-27 15 502 beschrieben.

Der Mengenanteil der säurespaltbaren Verbindungen in dem lichtempfindlichen Gemisch liegt im allgemeinen zwischen 8 und 65, vorzugsweise zwischen 14 und 44 Gew.-%, bezogen auf die nichtflüchtigen Bestandteile des Gemischs.

Vorzugsweise enthalten die Gemische ferner ein Polymeres, bevorzugt wasserunlösliches Bindemittel, das in organischen Lösungsmitteln löslich ist. Da sich als Entwicklerflüssigkeiten für die belichteten Kopierschichten mit Vorteil wäßrig-alkalische Lösungen einsetzen lassen und diese im allgemeinen gegenüber Entwicklern auf Basis organischer Lösungsmittel vorgezogen werden, werden insbesondere solche Bindemittel bevorzugt, die in wäßrigen Alkalien löslich oder mindestens quellbar sind.

Die Art und Menge der wasserunlöslichen Bindemittel kann je nach Anwendungszweck verschieden sein ; bevorzugt sind Anteile am Gesamtfeststoff zwischen 30 und 90, besonders bevorzugt 55-85 Gew.-%.

Die bei vielen Positiv-Kopiermaterialien bewährten Phenolharze, vor allem Novolake, haben sich auch bei den erfindungsgemäß verwendeten Gemischen als besonders brauchbar und vorteilhaft erwiesen. Sie fördern die starke Differenzierung zwischen den belichteten und unbelichteten Schichtpartien beim Entwickeln, besonders die höher kondensierten Harze mit substituierten Phenolen, z. B. Kresolen, als Formaldehyd-Kondensationspartner. Die Novolake können auch in bekannter Weise durch Umsetzung eines Teils ihrer Hydroxygruppen, z. B. mit Chloressigsäure, Isocyanaten, Epoxiden oder Carbonsäureanhydriden, modifiziert sein. Andere alkalilösliche Harze, wie Mischpolymerisate aus Maleinsäureanhydrid und Styrol, Vinylacetat und Crotonsäure, Methylmethacrylat und Methacrylsäure

3

und dgl. sind ebenfalls als Bindemittel geeignet.

Zusätzlich können noch zahlreiche andere Harze mitverwendet werden, die entweder wasserlöslich oder aber alkaliunlöslich sein können, bevorzugt Vinylpolymerisate wie Polyvinylacetate, Polyacrylate, Polyvinyleter und Polyvinylpyrrolidone, die selbst durch Comonomere modifiziert sein können. Der günstigste Anteil an diesen Harzen richtet sich nach den anwendungstechnischen Erfordernissen und dem Einfluß auf die Entwicklungsbedingungen und beträgt im allgemeinen nicht mehr als 20 % vom alkalilöslichen Harz. In geringen Mengen kann die lichtempfindliche Schicht für spezielle Erfordernisse wie Flexibilität, Haftung, Glanz etc. außerdem noch Substanzen wie Polyglykole, Celluloseether, z. B. Ethylcellulose, Netzmittel, Farbstoffe und feinteilige Pigmente enthalten.

Als strahlungsempfindliche Komponenten, die beim Bestrahlen vorzugsweise starke Säuren bilden bzw. abspalten, sind eine große Anzahl von bekannten Verbindungen und Mischungen, wie Diazonium-, Phosphonium-, Sulfonium- und Jodonium-Salze, Halogen-Verbindungen, o-Chinondiazidsulfochloride und Organometall-Organohalogen-Kombinationen geeignet.

Die genannten Diazonium-, Phosphonium-, Sulfonium- und Jodonium-Verbindungen werden in der Regel eingesetzt in Form ihrer in organischen Lösungsmitteln löslichen Salze, meist als Abscheidungsprodukt mit komplexen Säuren wie Borfluorwasserstoffsäure, Hexafluorphosphor-, Hexafluorantimon- und -arsensäure.

Grundsätzlich sind als halogenhaltige strahlungsempfindliche und Halogenwasserstoffsäure bildende Verbindungen alle auch als photochemische Radikalstarter bekannten organischen Halogenverbindungen, beispielsweise solche mit mehr als einem Halogenatom an einem Kohlenstoffatom oder an einem aromatischen Ring, brauchbar. Beispiele sind in den US-A-3 515 552, 3 536 489 und 3 779 778, der DE-C-26 10 842 und den DE-A1-27 18 259 und 22 43 621 beschrieben. Von diesen Verbindungen werden die s-Triazinderivate mit 2 Halogenmethylgruppen, insbesondere Trichlormethylgruppen, und einem aromatischen Substituenten im Triazinkern, wie sie in der DE-A1-27 18 259 beschrieben sind, bevorzugt. Die Wirkung dieser halogenhaltigen Verbindungen kann auch durch bekannte Sensibilisatoren spektral beeinflußt und gesteigert werden.

Die Menge des Starters kann je nach seiner chemischen Natur und der Zusammensetzung des Gemischs ebenfalls sehr verschieden sein. Günstige Ergebnisse werden erhalten mit etwa 0,1 bis 10 Gew.-%, bezogen auf den Gesamtfeststoff, bevorzugt sind 0,2 bis 5 %. Besonders für Kopierschichten von Dicken über 10 μm empfiehlt es sich, relativ wenig Säurespender zu verwenden.

Schließlich können dem lichtempfindlichen Gemisch noch lösliche oder auch feinteilige dispergierbare Farbstoffe sowie je nach Anwendungszweck auch UV-Absorber zugesetzt werden. Als Farbstoffe haben sich die Triphenylmethanfarbstoffe, insbesondere in der Form ihrer Carbinolbasen, besonders bewährt. Die günstigsten Mengenverhältnisse der Komponenten lassen sich im Einzelfall durch Vorversuche leicht ermitteln.

Als Schichtträger für die lichtempfindlichen Gemische eignen sich alle üblicherweise in der Technik in Kopierprozessen eingesetzten Materialien. Als Beispiele seien Kunststoffolien, Isolierplatten mit Kupferauflage, mechanisch oder elektrochemisch aufgerauhtes und ggf. anodisiertes Aluminium, Holz, Keramik, Glas und Silicium, dessen Oberfläche chemisch z. B. in Siliciumnitrid oder Siliciumdioxid umgewandelt sein kann, genannt. Voraussetzung für die Eignung ist, daß das Trägermaterial während der erfindungsgemäßen Erwärmung nicht in unerwünschter Weise verändert wird.

Unter Bestrahlung ist in dieser Beschreibung die Einwirkung aktinischer elektromagnetischer Strahlung im Wellenlängenbereich unterhalb etwa 500 μm zu verstehen. Alle in diesem Wellenlängenbereich emittierenden Strahlungsquellen sind prinzipiell geeignet.

Mit besonderem Vorteil werden Laserbestrahlungsgeräte, insbesondere automatische Verarbeitungsanlagen verwendet, die als Strahlungsquelle einen Argon-Ionen-Laser enthalten. Wenn in diesen Geräten die aufgrund der Lichtempfindlichkeit des Materials und der Leistung der Strahlungsquelle mögliche Durchsatzgeschwindigkeit genutzt werden soll, ist die Zwischenschaltung eines Erwärmungsschritts gemäß der Erfindung erforderlich. Selbstverständlich können auch alle üblichen Kopierlichtquellen verwendet werden.

Die Bestrahlung kann auch mit Elektronenstrahlen erfolgen. In diesem Falle können auch im üblichen Sinne nicht lichtempfindliche Säure abspaltende Verbindungen als Initiatoren der Solubilisierungsreaktion eingesetzt werden, z. B. halogenierte aromatische Verbindungen oder halogenierte polymere Kohlenwasserstoffe. Auch Röntgenstrahlen können zur Bilderzeugung verwendet werden.

Die bildmäßig belichtete oder bestrahlte Schicht kann in bekannter Weise mit praktisch den gleichen Entwicklern wie für handelsübliche Naphthochinondiazid-Schichten und Kopierlacke entfernt werden. Die wäßrigen Entwicklerlösungen können z. B. Alkaliphosphate, -silikate oder -hydroxide und ferner Netzmittel sowie ggf. kleinere Anteile organischer Lösungsmittel enthalten. In bestimmten Fällen sind auch Lösungsmittel-Wasser-Gemische als Entwickler brauchbar. Die Wahl des günstigsten Entwicklers kann durch Versuche mit der jeweils verwendeten Schicht ermittelt werden. Bei Bedarf kann die Entwicklung mechanisch unterstützt werden.

Im folgenden werden Beispiele für die Durchführung des erfindungsgemäßen Verfahrens angegeben.

In den Beispielen stehen Gewichtsteile (Gt) und Volumteile (Vt) im Verhältnis von g zu ccm. Prozent- und Mengenverhältnisse sind, wenn nichts anderes angegeben ist, in Gewichtseinheiten zu verstehen.

# 0 049 840

## Beispiel 1

Eine auf elektrolytisch aufgerauhtes und anodisiertes Aluminium ca. 2 μm dick aufgetragene Schicht der Zusammentzung

76,2 Gt Kresol-Formaldehyd-Novolak (Schmelzbereich 105-120 °C nach DIN 53181),
18,2 Gt Bis-diphenoxymethylether des Triethylenglykols,
1,4 Gt Trihydroxybenzophenon,
3,6 Gt 2-(4-Methoxy-naphth-1-yl)-4,6-bis-trichlormethyl-s-triazin und
0,6 Gt Kristallviolett-Base

wurde durch eine Halbtonvorlage mit 13 Stufen der optischen Dichte von je 0,15 unter einer 5 kW-Metallhalogenidlampe im Abstand von 110 cm 12 Sekunden belichtet und nach 30 Sekunden mit dem Entwickler der folgenden Zusammensetzung entwickelt :

5,5 Gt Natriummetasilikat × 9 $H_2O$,
3,4 Gt Trinatriumphosphat × 12 $H_2O$,
0,4 Gt Natriumdihydrogenphosphat, wasserfrei,
90,7 Gt Wasser.

Das positive Bild wies eine gedeckte Keilstufe 5 auf, die Stufe 2 zeigte noch sehr schwache Schichtreste. Der Versuch wurde in sonst gleicher Weise wiederholt, nur wurde zwischen Belichtung und Entwicklung eine Wartezeit von 10 Minuten eingehalten. Es resultierte eine gedeckte Keilstufe 6, und die Stufe 3 war tonfrei, entsprechend einem Empfindlichkeitsgewinn von ca. 40-50 %. Das gleiche Ergebnis wurde erzielt, wenn die Schicht in einem Trockenschrank zwischen Belichtung und Entwicklung 50 Sekunden auf 80 °C erhitzt wurde.

## Beispiel 2

Das Beispiel 1 wurde wiederholt, wobei der verwendete Bis-orthoester durch gleiche Gewichtsmengen an Bis-diphenoxymethylether des Bisphenols A ersetzt und die Schicht auf gebürstetes Aluminium aufgetragen wurde. Die Druckplatte wurde 80 Sekunden unter den im Beispiel 1 genannten Bedingungen belichtet und 30 Sekunden danach mit dem Entwickler des Beispiels 1 entwickelt. Es wurde ein positives Bild mit einer gedeckten Keilstufe 5 und einer fast tonfreien Stufe 2 erhalten ; nach 4 Minuten Wartezeit zwischen Belichtung und Entwicklung wurde eine gedeckte Stufe 6 und eine freie Stufe 4 ermittelt. Dieses Ergebnis ließ sich auch nach 1 Minute Erwärmung der Schicht auf 70 °C erzielen.

## Beispiel 3

Aluminiumplatten mit elektrochemisch aufgerauhter, anodisierter und mit einer 0,1 %igen wäßrigen Lösung von Polyvinylphosphonsäure vorbehandelter Oberfläche wurden mit einer Lösung aus

5,6 Gt Kresol-Formaldehyd-Novolak nach Beispiel 1,
0,80 Gt Polyacetal aus n-Pentanal und Triethylenglykol,
1,25 Gt des durch Umsetzung von 4-Oxa-2-methyl-2-hydroxymethyl-octan-1,8-diol mit Orthoameisensäuretrimethylester erhaltenen Polyorthoesters,
0,28 Gt 2-(Acenaphth-5-yl)-4,6-bis-trichlormethyl-s-triazin,
0,05 Gt Kristallviolett-Base und
0,12 Gt Trihydroxybenzophenon in
30 Gt Ethylenglykolmonomethylether,
52,9 Gt Tetrahydrofuran und
9,0 Gt Butylacetat

beschichtet, so daß nach dem Trocknen eine Schichtdicke von 2,5 μm resultierte. Die Platte wurde 12 Sekunden unter den in Beispiel 1 genannten Bedingungen belichtet und 30 Sekunden nach Ende der Belichtung mit dem Entwickler des Beispiels 1 entwickelt. Wenn die Zeit vor der Entwicklung auf 10 Minuten ausgedehnt wurde, verschoben sich offene und gedeckte Keilstufen um 2 Einheiten in Richtung höherer praktischer Lichtempfindlichkeit. Wenn die Platte nach der Belichtung mit einer Geschwindigkeit von 0,75 m/Minute durch die mit langwelligen IR-Strahlern bestückte, ca. 30 cm lange Heizzone des « Microcoaters Modell 9 » der Fa. Gyrex, Santa Barbara, Ca., USA, geschickt wurde, wobei mit handelsüblichen Temperaturmeßstreifen auf der Unterseite der Platte eine Temperatur zwischen 88 und 93 °C gemessen wurde, so wurde nach der Entwicklung das gleiche Kopierergebnis erhalten wie bei der 10 Minuten bei Raumtemperatur gelagerten Platte. Wenn belichtete, in der oben beschriebenen Weise nacherhitzte Platten nach Abschluß des Erwärmungsschrittes nochmals 5, 10 oder 20 Minuten bei

5

Raumtemperatur gelagert und dann entwickelt wurden, wurde kein Unterschied der Kopierergebnisse zu direkt nach dem Erwärmungsschritt entwickelten Platten mehr beobachtet.

Das bei einer Wartezeit von nur 30 Sekunden zwischen Belichtung und Entwicklung erhaltene Kopierergebnis wurde auch bei längeren Wartezeiten beobachtet, wenn die belichteten Platten 5, 10 oder 15 Minuten bei − 26 °C aufbewahrt und dann entwickelt wurden. Wenn nach der Wartezeit bei niedriger Temperatur vor dem Entwickeln noch eine entsprechend lange Zeit bei Raumtemperatur gewartet oder die Platte erwärmt wurde, entsprach das Kopierergebnis dem ohne Kühlphase erhaltenen Ergebnis.

<center>Beispiel 4</center>

Eine Aluminiumplatte mit mechanisch aufgerauhter Oberfläche wurde mit einer 1,7 μm dicken Schicht der folgenden Zusammensetzung versehen :

75 Gt Novolak nach Beispiel 1,
49 Gt Chlorparaffinharz und
21 Gt Bis-(5-ethyl-5-butyl-1,3-dioxan-2-yl)-ether des 2-Ethyl-2-butyl-propan-1,3-diols.

Ein Quadrat der Plattenoberfläche mit 31,7 mm Kantenlänge, d. h. 10 cm² Fläche, wurde 4 Sekunden lang mit Elektronenstrahlung einer Stromstärke von 5 μA bei 11 kV zeilenweise bestrahlt und die Platte 10 Minuten nach Ende der Bestrahlung 1 Minute in den Entwickler aus Beispiel 1 getaucht. Die bestrahlte Schichtfläche wurde völlig abgelöst. Wurde die 10-minütige Wartezeit nicht eingehalten und sofort nach Ende der Bestrahlung 1 Minute entwickelt, ging die bestrahlte Schicht nicht in Lösung. Wenn die Platte nach der Bestrahlung sofort 1 Minute im Trockenschrank auf 80 °C erwärmt und dann schnell auf Raumtemperatur abgekühlt und wie angegeben entwickelt wurde, erwies sich das bestrahlte Flächenelement wieder als löslich, d. h. die Bestrahlung mit einer Ladungschichte von 2 μC/cm² ist für die Solubilisierung ausreichend.

<center>Beispiele 5-9</center>

Mit einer Lösung von

5,0 Gt Novolak nach Beispiel 1,
1,5 Gt durch Säure spaltbare Verbindung,
0,26 Gt Säurespender und
0,04 Gt Kristallviolett-Base in
93,2 Gt Butan-2-on

wurden Platten aus elektrochemisch aufgerauhtem, anodisiertem und mit Polyvinylphosphonsäure vorbehandeltem Aluminium schleuderbeschichtet, so daß nach dem Trocknen eine Schichtdicke von Ca. 1,8 μm resultierte. Die Platten wurden unter den Bedingungen des Beispiels 1 belichtet und vor der Entwicklung mit einer Lösung von

0,8 Gt Natriummetasilikat × 9 H$_2$O,
0,5 Gt Natriumhydroxid und
0,8 Gt n-Butanol in
97,9 Gt Wasser

verschiedene Zeiten bei Raumtemperatur gelagert bzw. zusätzlich 1 Minute auf 60 °C erhitzt. In diesen Fällen bedeutet der Ausdruck « Gesamtzeit » in Tabelle 1 die gesamte zwischen Belichtung und Entwicklung einschließlich der Erwärmung verstrichene Zeit.
Eingesetzt wurden in den Beispielen 5-9 als säurespaltbare Verbindungen

Beispiel 5 : 2-[4-(2,4-Dichlor-phenoxy)-phenoxy]-5,5-dimethyl-oxazolin-4-on,
Beispiel 6 : der Bis-3,4-dihydro-naphth-2-yl-ether des 1,4-Butandiols,
Beispiel 7 : der Bis-3,4-dihydro-naphth-2-yl-ether des Triethylenglykols,
Beispiel 8 : N-Diphenoxymethyl-4-methyl-azetidin-2-on,
Beispiel 9 : der Bis-tetrahydropyran-2-yl-ether des 4,4'-Dihydroxy-diphenylsulfons.

Als Säurespender diente in den Beispielen 5-8 2-(4-Ethoxy-naphth-2-yl)-4,6-bis-trichlormethyl-s-triazin, im Beispiel 9 2-(4-Methoxy-styryl)-4,6-bis-trichlormethyl-s-triazin.

<center>(Siehe Tabelle 1 Seite 7 f.)</center>

<center>6</center>

0 049 840

Tabelle 1

| Bei-spiel | Bel.-Zeit (Sekunden) | Gesamtzeit (Sekunden) | Erwärmung 60 Sek/60°C | Keilstufen frei | gedeckt ab Stufe |
|---|---|---|---|---|---|
| 5 | 12 | 14 | nein | 0 | 4 |
| | | 600 | nein | 2 | 6 |
| | | 75 | nein | 0 | 5 |
| | | 75 | ja | 2 | 5 |
| 6 | 12 | 14 | nein | 2 | 6 |
| | | 600 | nein | 4 | 7 |
| | | 75 | nein | 2 | 6 |
| | | 75 | ja | 4 | 7 |
| 7 | 12 | 14 | nein | 0 | 3 |
| | | 600 | nein | 2 | 5 |
| | | 75 | nein | 0 | 4 |
| | | 75 | ja | 2 | 5 |
| 8 | 12 | 14 | nein | 0 | 4 |
| | | 600 | nein | 2 | 5 |
| | | 75 | nein | 0 | 4 |
| | | 75 | ja | 2 | 4 |
| 9 | 40 | 14 | nein | 1 | 6 |
| | | 600 | nein | 3 | 7 |
| | | 75 | nein | 1 | 6 |
| | | 75 | ja | 3 | 7 |

Beispiel 10

Ein Druckplatte des Formats 580 mm × 420 mm, die aus einer elektrochemisch aufgerauhten, anodisierten und mit Polyvinylphosphonsäure behandelten Aluminiumfolie und einer Kopierschicht der folgenden Zusammensetzung

76,0 Gt Novolak nach Beispiel 1,
20,15 Gt des polymeren Orthoesters, hergestellt durch Kondensation von Orthoameisensäuretrimethylester mit 4-Oxa-6,6-bis-hydroxymethyl-octan-1-ol,
3,7 Gt 2-(4-Ethoxy-naphth-1-yl)-4,6-bis-trichlormethyl-s-triazin und
0,15 Gt Kristallviolett-Base

bestand, wurde in einer Laserite$^{(R)}$-Anlage mit der kohärenten UV-Strahlung eines Argon-Ionen-Lasers zeilenweise in der Art belichtet, daß 400 Zeilen/cm geschrieben wurden.
Die Bebilderung der gesamten Platte erfolgte in 96 Sekunden. Die Belichtungsenergie auf der Plattenoberfläche betrug 4,2 mJ/cm$^2$.
Wenn die belichtete Platte unmittelbar nach Beendigung der Belichtung mit dem Entwickler aus Beispiel 1 entwickelt wurde, nahm sie beim Einfärben mit fetter Farbe auch an den Nichtbildstellen noch

7

stellenweise Farbe an. Wenn die Platte jedoch vor dem Entwickeln durch ein Gerät laufen gelassen wurde, das mit einer etwa 50 cm langen Heizzone, bestückt mit vier mittelwelligen IR-Strahlern zu je 800 W, ausgerüstet war, so daß in etwa 40 Sekunden eine mit Temperaturmeßstreifen entsprechend Beispiel 3 auf der Plattenunterseite bestimmte Temperatur von 71-77 °C erreicht wurde, und die Platte dann entwickelt wurde, ließ sie sich anschließend tonfrei einfärben und lieferte in einer Offsetdruckmaschine hohe Auflagen.

## Ansprüche

1. Verfahren zur Herstellung von Reliefkopien durch bildmäßiges Bestrahlen eines strahlungsempfindlichen Kopiermaterials aus einem Schichtträger und einer strahlungsempfindlichen Schicht, die

a) eine bei Bestrahlung Säure abspaltende Verbindung und
b) eine Verbindung, die mindestens eine durch Säure spaltbare C—O—C-Gruppe aufweist,

enthält, und Auswaschen der bestrahlten Schichtbereiche mittels eines Entwicklers, dadurch gekennzeichnet, daß man zur Erhöhung der Löslichkeit der bestrahlten Bereiche das bildmäßig bestrahlte Kopiermaterial vor dem Auswaschen kurze Zeit erwärmt.

2. Verfahren nach Anspruch 1, dadurch gekennzeichnet, daß man das bildmäßig bestrahlte Kopiermaterial 0,5 bis 2 Minuten erwärmt.

3. Verfahren nach Anspruch 1, dadurch gekennzeichnet, daß man das bildmäßig bestrahlte Kopiermaterial auf eine Temperatur im Bereich von 40 bis 130 °C erwärmt.

4. Verfahren nach Anspruch 1, dadurch gekennzeichnet, daß man die bildmäßige Bestrahlung mit Laserstrahlung durchführt.

5. Verfahren nach Anspruch 1, dadurch gekennzeichnet, daß man die bestrahlten Schichtbereiche mit einer wäßrig-alkalischen Lösung auswäscht.

6. Verfahren nach Anspruch 1, dadurch gekennzeichnet, daß man als bei Bestrahlung Säure abspaltende Verbindung ein s-Triazinderivat verwendet, das zwei Halogenalkylgruppen und eine Arylgruppe als Substituenten im Triazinkern enthält.

7. Verfahren nach Anspruch 1, dadurch gekennzeichnet, daß man als säurespaltbare Verbindung eine Verbindung mit mindestens einer Orthocarbonsäureester- oder einer Carbonsäureamidacetalgruppierung, eine Verbindung mit mindestens einer Acetalgruppe, eine Verbindung mit mindestens einer Enolethergruppe oder eine Verbindung mit mindestens einer Acyliminocarbonatgruppe im Molekül verwendet.

## Claims

1. A process for the preparation of relief copies by imagewise irradiating a radiation-sensitive copying material comprising a layer support and a radiation-sensitive layer containing

a) a compound which upon irradiation cleaves off acid, and
b) a compound possessing at least one acid-cleavable C—O—C group,

and by washing out the irradiated layer areas by means of a developer, said process being characterized in that the imagewise irradiated copying material is heated for a short time before the washing-out step, in order to increase the solubility of the irradiated areas.

2. A process as claimed in Claim 1, wherein the imagewise irradiated copying material is heated for 0.5 to 2 minutes.

3. A process as claimed in Claim 1, wherein the imagewise irradiated copying material is heated to a temperature in a range of between 40 and 130 °C.

4. A process as claimed in Claim 1, wherein the imagewise irradiation is performed by means of laser beams.

5. A process as claimed in Claim 1, wherein the irradiated layer areas are washed out with an aqueous-alkaline solution.

6. A process as claimed in Claim 1, wherein the compound, which upon irradiation cleaves off acid, is a s-triazine derivative which contains two halogenoalkyl groups and an aryl group as the substituent in the triazine nucleus.

7. A process as claimed in Claim 1, wherein the acid-cleavable compound is a compound possessing at least one orthocarboxylic acid ester grouping or carboxylic acid amide acetal grouping, a compound possessing at least one acetal group, a compound possessing at least one enolic ether group or a compound possessing at least one acyliminocarbonate group in the molecule.

## Revendications

1. Procédé pour la préparation de copies en relief par exposition selon une image d'un matériau à copier sensible aux radiations, constitué d'un support de couche et d'une couche sensible aux radiations, qui contient

a) un composé engendrant un acide par irradiation et
b) un composé qui montre au moins un groupe C—O—C scindable par un acide ;

et par lavage des régions irradiées de la couche sensible aux radiations au moyen d'un révélateur, lequel procédé est caractérisé en ce que, pour augmenter la solubilité des régions irradiées, le matériau à copier irradié selon une image est chauffé pendant peu de temps avant le lavage.

2. Procédé selon la revendication 1, caractérisé en ce qu'on chauffe le matériau à copier irradié selon une image pendant de 0,5 à 2 minutes.

3. Procédé selon la revendication 1, caractérisé en ce qu'on chauffe le matériau à copier irradié selon une image à une température comprise entre 40 et 130 °C.

4. Procédé selon la revendication 1, caractérisé en ce qu'on effectue l'irradiation selon une image avec un rayonnement laser.

5. Procédé selon la revendication 1, caractérisé en ce qu'on lave la surface de la couche irradiée avec une solution aqueuse-alcaline.

6. Procédé selon la revendication 1, caractérisé en ce que, comme composé engendrant un acide par irradiation, on utilise un dérivé de s-triazine qui contient deux groupes halogénoalcoyle et un groupe aryle comme substituants dans le noyau triazine.

7. Procédé selon la revendication 1, caractérisé en ce que comme composé scindable par un acide, on utilise un composé ayant au moins un groupe ester d'acide orthocarboxylique ou acétal d'amide carboxylique, un composé ayant au moins un groupe acétal, un composé ayant au moins un groupe éther énolique ou un composé ayant au moins un groupe acyliminocarbonate dans la molécule.